(19) Europäisches Patentamt / European Patent Office / Office européen des brevets

(11) **EP 2 888 070 B1**

(12) **EUROPEAN PATENT SPECIFICATION**

(45) Date of publication and mention
of the grant of the patent:
**31.01.2018 Bulletin 2018/05**

(21) Application number: **13802104.3**

(22) Date of filing: **23.08.2013**

(51) Int Cl.:
*B23K 15/00* (2006.01)       *H01J 37/21* (2006.01)
*H01J 37/304* (2006.01)

(86) International application number:
**PCT/IB2013/056836**

(87) International publication number:
**WO 2014/030144 (27.02.2014 Gazette 2014/09)**

(54) **METHOD OF OPERATIONAL CONTROL OF ELECTRON BEAM WELDING BASED ON THE SYNCHRONOUS INTEGRATION METHOD**

VERFAHREN ZUR BETRIEBSSTEUERUNG EINER ELEKTRONENSTRAHLSCHWEISSUNG AUF BASIS VON SYNCHRONEN INTEGRATIONSVERFAHREN

PROCÉDÉ DE COMMANDE FONCTIONNELLE DU SOUDAGE PAR FAISCEAU D'ÉLECTRONS BASÉ SUR LA MÉTHODE D'INTÉGRATION SYNCHRONISÉE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **24.08.2012 RU 2012136243**

(43) Date of publication of application:
**01.07.2015 Bulletin 2015/27**

(73) Proprietor: **Federal State Budgeted Education Institution for**
**Higher Professional Education Perm National Research Polytechnic University**
**Perm 614990 (RU)**

(72) Inventors:
• **TRUSHNIKOV, Dmitriy Nikolayevich**
**Perm 614022 (RU)**

• **BELENKII, Vladimir Yakovlevich**
**Perm 614990 (RU)**

(74) Representative: **Gebauer, Dieter Edmund**
**Splanemann**
**Patentanwälte Partnerschaft**
**Rumfordstraße 7**
**80469 München (DE)**

(56) References cited:
**GB-A- 2 026 732       GB-A- 2 345 149**
**JP-A- S55 100 886**

• **DATABASE WPI Week 198318 Thomson Scientific, London, GB; AN 1983-G0370K XP002723843, -& SU 938 256 A1 (CHEBOKSARY PROMPRIB) 25 June 1982 (1982-06-25)**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

TECHNICAL FIELD

The invention relates to the field of electron beam welding and can be used in electron beam welding of structural materials with control and management of the power density of the electron beam directly within the welding process.

BACKGROUND OF THE INVENTION

There is a known method of electron beam welding with control of the power density of the electron beam in the metal interaction zone, in which the electron beam is focused based on a waveform obtained by isolating and processing the alternating components of the secondary current with intersecting frequency spectra (Inventor's Certificate No. 1468700, B23K15/00, 1989).

The known method provides satisfactory precision of control in focusing the electron beam, but its operating speed is low. This is due to the fact that the method's secondary radiation characteristics are highly dependent on the focusing lens current, have a dead zone, and have two values of focusing lens current that provide waveform characteristics that are equal in magnitude. As a result, systems for operational control of the focusing of the electron beam using the known method provide poor-quality scanning, which substantially limits the operating speed of these systems and negatively affects the quality of the welded joint.

The method closest to the claimed method in its technical essence and achievable effect is a method of electron beam welding in which the power density of the electron beam is modulated by superimposing an alternating voltage with a specific frequency on the beam current and/or the focusing lens current of the electron gun. The focusing of the electron beam is regulated by the alternating component of the secondary current that has a frequency equal to that of the modulation of the beam's power density; determination is made of the two maxima of a function of the focusing current, amplitude, and/or unnormalized spectral density of the component of the secondary current with a frequency equal to that of the modulation of the power density of the electron beam; and the beam is focused using the minimum value of the amplitude and/or unnormalized spectral density of this component, regulating the focusing lens current in the interval between its values that correspond to the maxima of the amplitude and/or spectral density of the component (RF Patent No. 2183153, B23K 15/00, 2002).

A shortcoming of the known method is that it provides satisfactory precision of control in focusing the electron beam only when welding with a modulated beam, but operational control while welding requires low-frequency exploratory scanning of the electron beam's focus, which negatively affects the quality of the welded joint.

JP S55 100886 A, on which the preamble of claim 1 is based, describes a method in which voltage oscillations are registered by the direct detection of a variable which is proportional to the accelerating voltage. During oscillations of a focal spot location high frequency beam jitters are employed which makes it possible to decrease the specific capacity of the electron beam during the oscillation. This document is silent on the use of electrodes for sensing the secondary current.

GB 2026732 A describes a method in which the measurement of high voltage oscillations is replaced by the measurement of the secondary current bursts or the ripple on the current from the high voltage supply. This document is silent on defining a focus. Specifically, during the ripple of the focal spot location, similar to JP S55 100886 A, the high frequency oscillation is introduced or the current is reduced. The focusing mode is defined as an average level of current focus, characterizing time averaged specific capacity.

DATABASE WPI, Week 198318, Thomson Scientific London GB, AN 1983-G0370K & SU 938 256 B (CHEBOKSARY PROMPRIB) 25 June 1982 and GB 2345149 A describe some software solutions realizing the synchronous integration method in technical fields different from the claimed invention.

SUMMARY OF THE INVENTION

The problem solved by the invention consists of the provision of a method of electron beam welding given increased precision of operational control in the focusing of the electron beam when deep welding using an oscillating electron beam.

The technical result obtainable by the invention is an increase in the quality of welded joints formed when deep welding using an oscillating electron beam. This object is obtained by a method according to claim 1. Preferred embodiments are indicated in the subclaims.

Specifically, the electron beam welding is performed with a sinusoidally or linearly oscillating electron beam in the frequency range from 300 to 2,000 Hz; during the welding process, the waveform of the secondary current in the plasma is measured; the original waveform of the secondary current in the plasma is filtered and rectified; the filtered-and-rectified or original waveform of the secondary current in the plasma is processed using the synchronous integration method; the magnitude of the delay function, which results from processing the secondary waveform using the synchronous integration method, is measured relative to the waveform of the current in the deflection coils; then the focusing current is controlled while holding the value of the delay function mentioned above at a constant level which corresponds to a specified magnitude of the power density of the electron beam.

The claimed method makes it possible with high precision to implement operational control of the focusing of the electron beam with the use of additional exploratory scanning of the focus, thanks to the use of an additional data parameter when implementing a sequence of actions in accordance with the invention's claims. The high-frequency oscillating electron beam applied at the same time further improves the quality of the welded joint.

The advantages of the method which have been mentioned ensure high-quality deep welding using an oscillating electron beam and make it possible with high precision to implement operational control of the focusing of the electron beam without the use of additional exploratory scanning of the focus.

BRIEF DESCRIPTION OF THE DRAWINGS

The invention is hereinafter illustrated with a description of the preferred embodiments, with references to the accompanying drawings in which:

Fig. 1      depicts the structural layout of an apparatus designed to implement the claimed method;

Fig. 2      depicts a plot of the reference waveform $g(t)$ for the realization of synchronous integration, which was generated from the waveform in the deflection coils and which was rectangular oscillations with a low duty cycle;

Fig. 3      depicts function $S(\tau)$, which is the result of processing the secondary waveform using the synchronous integration method and depends on the shift of the reference waveform (a) and on the waveform in the

$$S(\tau) = \int_0^{t_0} g(t + \tau) \cdot Data(t)dt \text{ ,}$$

deflection coils (b) according to the formula      where $t_0$ is the sample time;

Fig. 4      depicts the experimentally-obtained dependence of the delay $\Delta\tau_0$ of the function $S(\tau)$ on the level of focus $\Delta I_f$ of the electron beam, with additional experimental control points plotted;

Fig. 5      presents a chart of the results of performing electron beam welding of steel using 3 kW of power for 5 different levels of focus of the electron beam $\Delta I_f$;

Fig. 6      depicts the distribution of the spectral density $A_f$ as a function of frequency $f$ in the oscillation spectrum of the waveform of the secondary current in the plasma when welding an item made of 12X18H10T stainless steel.

DETAILED DESCRIPTION OF THE INVENTION

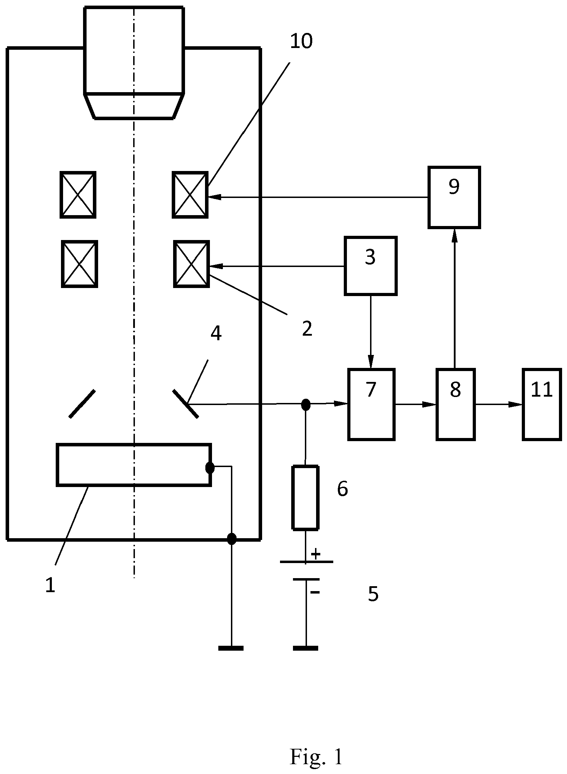

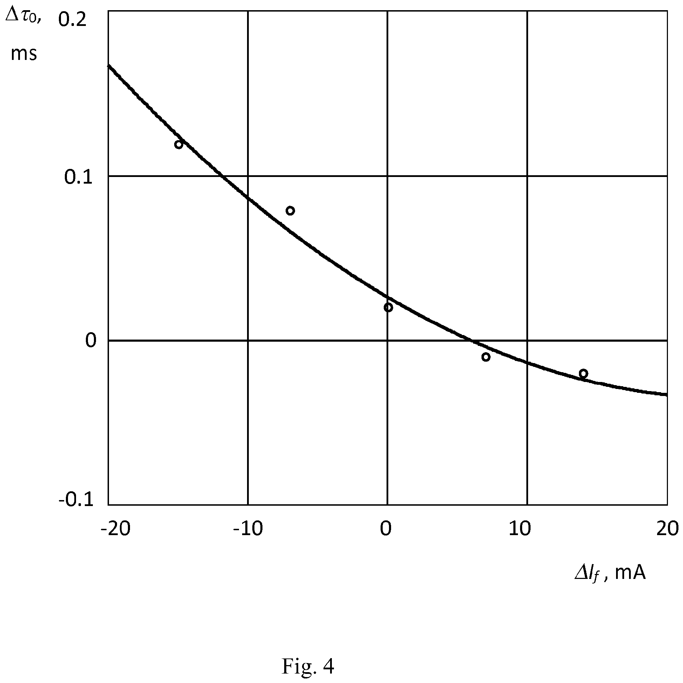

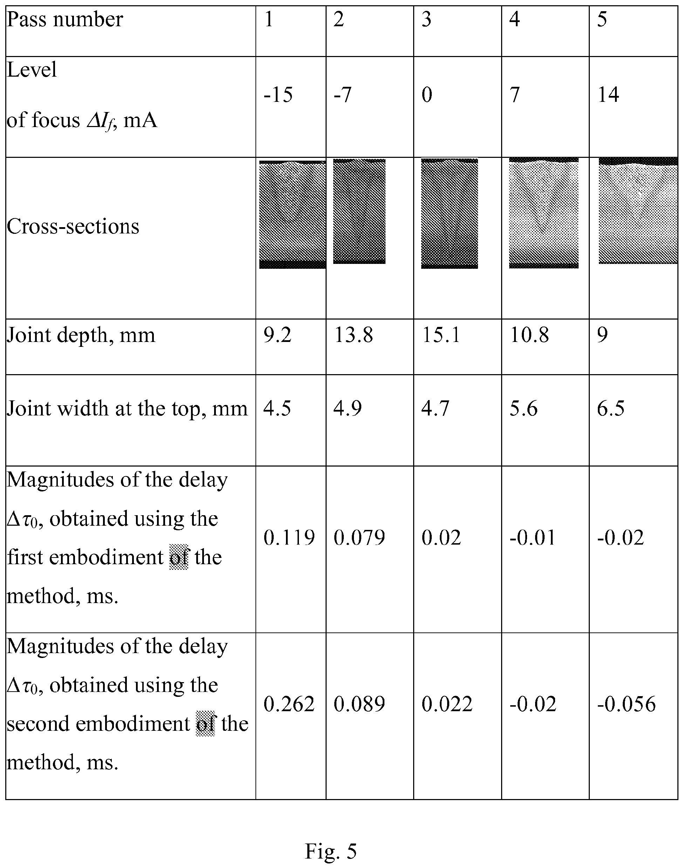

In Fig. 1, the structural layout of an apparatus designed to implement the claimed method is presented. While welding an item 1, the electron beam is oscillated in the apparatus for electron beam welding by injecting linear, sawtoothed, or sinusoidal oscillations into the current of the deflection coils 2 by means of the block 3 for controlling the currents of the deflection coils $I_{defl}$. The oscillations are in the frequency range from 300 to 2,000 Hz. During the process of welding, the secondary current and the current of the deflection coils 2 is regulated in the circuit containing an electron collector 4, bias supply 5, and termination resistor 6. The voltage from the termination resistor 6, which is proportional to the magnitude of the original waveform of the secondary current in the plasma, is filtered and rectified in processing unit 7. In this same unit 7, the filtered-and-rectified or original waveform of the secondary current in the plasma is processed using the synchronous integration method together with the waveforms of the currents of the deflection coils $I_{defl}$. The processing produces the function $S(\tau)$, which is the result of processing the secondary waveform using the synchronous integration method, and the magnitude of the delay $\Delta\tau_0$ or $\Delta S$ of the function $S(\tau)$ relative to the waveform of the current in the deflection coils (Fig. 4). The magnitude of the delay $\Delta\tau_0$ or $\Delta S$ of the function $S(\tau)$ relative to the waveform of the current in the deflection coils is a monotonic function of the level of focus $\Delta I_f$ of the electron beam (Fig. 5) and becomes zero when the electron beam is sharply focused. The control unit 8 and the block 9 for controlling the current of the focusing coils 10 regulate the current of the focus of the electron beam, while holding the magnitude of the delay mentioned above, $\Delta\tau_0$ or $\Delta S$ of the function $S(\tau)$, at a constant level which corresponds to a specified level of focus of the electron beam relative to the surface of the item. In particular, holding the magnitude of the delay equal to zero ensures maximum weld penetration and speed for a given power level, which corresponds to the maximum power density in the weld zone. The function $S(\tau)$ and the magnitude of the delay $\Delta\tau_0$ or $\Delta S$ of the function are displayed on a visualization device 11.

In accordance with the claimed method, it is preferable for the oscillation of the electron beam to occur along the joint being welded. However, it should be noted that oscillations across the joint may also be used with the X-shaped method and with the application of other specially-shaped trajectories in order to further improve the welding quality.

Experimental testing of the method was performed on specimens of 12X18H10T and 15X5M steel on an electron beam welding apparatus with an inverting power supply with an accelerating voltage of 60 kV and 6 kW of power. The electron beam was oscillated by injecting periodic linear oscillations into the current of the deflection coils $I_{\mathrm{defl}}$. The distance from the face of the electron gun to the item was 100 mm. The experiment was actively planned. There were four variables: welding power - P; scan size - 2A; oscillation frequency of the electron beam - f; level of focus of the electron beam - $\Delta I_f = I_f - I_{f0}$, the difference between the values of the focusing currents when welding, $I_f$, and the sharp-focus current that maximizes penetration, $I_{f0}$. The welding speed was 5 mm/s. The weld penetration without the oscillation of the electron beam and the sharp focusing was 10-18 mm. The range of the variables for each run is presented in Table 1.

*Table 1*

| Variables | $\Delta I_f$, mA | f, Hz | 2 A, mm | P, kW |
|---|---|---|---|---|
| Lower bound of variability | -14 | 50 | 0.4 | 2 |
| Upper bound of variability | 14 | 1400 | 3.5 | 4 |

In accordance with the first embodiment of the invention, during welding passes the current in the circuit of the secondary electron collector 4, which is located on the face of the electron gun and has a +50V potential (Fig. 1), was recorded using a computer-based data measurement system equipped with a multichannel analog-to-digital interface. Waveforms proportional to the current in the deflection coils 2 were recorded simultaneously. The results of the recording were written to a file for subsequent processing. The sampling rate of the analog-to-digital conversion in the experiments conducted was 400 kHz on two measuring channels. Some of the experiments were conducted with a sampling rate of 2 MHz. Each of the melted specimens was subsequently processed to prepare large cross-sections.

The waveform of the secondary current in the plasma from the electron collector installed over the weld zone and the waveform of the current in the deflection coils were processed using the computer-based data measurement system equipped with a multichannel analog-to-digital interface.

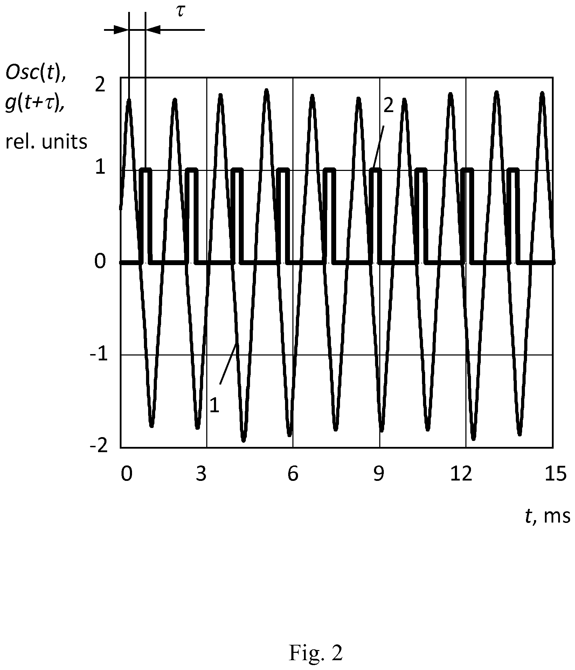

The reference waveform $g(t)$ for the realization of synchronous integration according to the present invention was generated from the waveform in the deflection coils and was rectangular oscillations with a low duty cycle (Fig. 2).

Illustrated in Fig. 2:

Reference waveform $g(t)$: 1 - a trace of the deflecting current along the coil junction ($Osc(t)$); 2 - the generated reference waveform ($g(t+\tau)$,); 3 - the shift of the reference waveform relative to the waveform of the deflection coils ($\tau$).

The reference waveform $g(t+\tau)$, shifted by time $\tau$ ($0<\tau<T$, where $T$ is the period of the waveform in the deflection coils), was multiplied by the waveform of the secondary current $Data(t)$ and then integrated (summed or averaged) over time t.

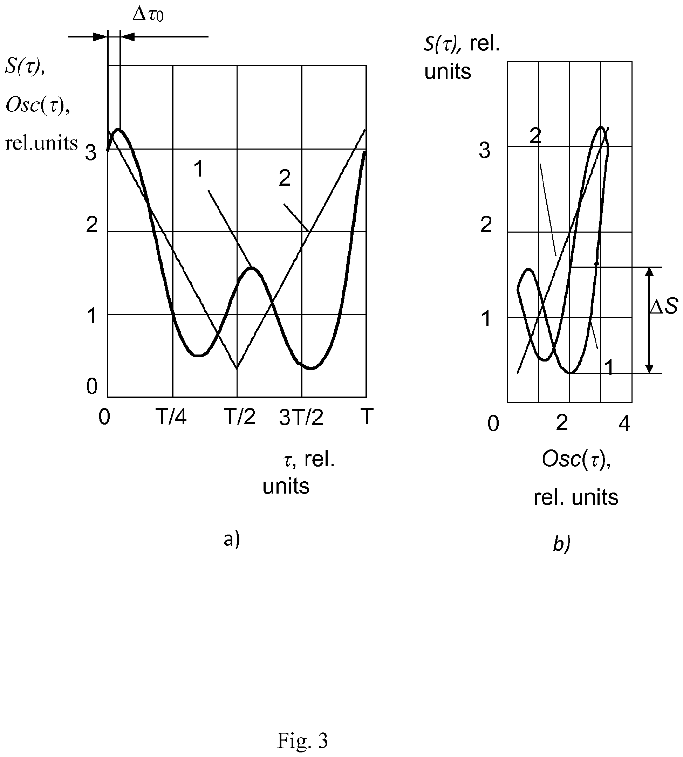

The result of these transformations was the function $S(\tau)$ (Fig. 3), which represents the change in the result of synchronous detection as a function of the shift in the reference waveform.

$$S(\tau) = \int_0^{t_0} g(t+\tau) \cdot Data(t)\,dt\ ,$$

where $t_0$ is the sampling time (which was 300 ms).

According to the models constructed for the magnitude of the delay $\Delta\tau_0$ of the function $S(\tau)$ relative to the waveform of the current in the deflection coils and for the weld penetration as a function of the variables in Table 1, the correlation between the model for the magnitude of the delay $\Delta\tau_0$ of the function $S(\tau)$ and the waveform of the current in the deflection coils is 0.957, which indicates a direct relationship between the resultant functions and the parameters being observed.

In Fig. 4 the dependence of the magnitude of the delay $\Delta\tau_0$ on the level of focus $\Delta I_f$ is presented, constructed based on the obtained regression equation. The points represent additional experimental data obtained to verify a good fit for fixed values of all of the variables in Table 1 besides $\Delta I_f$. The curve in Fig. 4 decreases monotonically as the level of focus increases, and it becomes zero in the region of sharp focus which ensures maximum weld penetration. Similar results were obtained for $\Delta S$ (Fig. 3b), which also describes the magnitude of the delay $\Delta\tau_0$ of the function $S(\tau)$ relative to the waveform of the current in the deflection coils.

The method was tested on specimens of 15X5M steel in an electron beam welding apparatus with a ELA-60/60 power supply with 3.6 kW of welding power.

Fig. 5 shows a chart of performing electron beam welding of steel with a 3-kW electron beam for 5 different levels of focus of the electron beam $\Delta I_f$ ($\Delta I_f = I_f - I_{fo}$; the level of focus determined by the difference between the values of the focusing current when welding and the sharp-focus current that maximizes weld penetration). The magnitudes of the delay $\Delta\tau_0$ of the function $S(\tau)$ relative to the waveform of the current in the deflection coils are presented, having been obtained in accordance with the claimed method. The sign and magnitude of the delay $\Delta\tau_0$ of the function $S(\tau)$ depend on the level of focus $\Delta I_f$, which decreases monotonically from positive values when under-focused to negative values when using an over-focused electron beam (Fig. 4).

Fig. 5 also depicts cross-sections and geometric characteristics of the penetration obtained when welding in each configuration. Clearly, the weld penetration h reached its maximum value when the electron beam was focused, at which point the magnitudes of the delay $\Delta\tau_0$ of the function $S(\tau)$ were observed to be 0, as confirmed by the chart in Fig. 5. The maximum ratio of weld penetration h to joint width at the top d is observed at the same point.

Thus, the indicated data parameter makes it possible to identify when the electron beam is focused when electron beam welding, without the application of additional low-frequency exploratory scanning of the focus.

There were similar results when welding all of the materials used in the experiments, in all of the configurations described above.

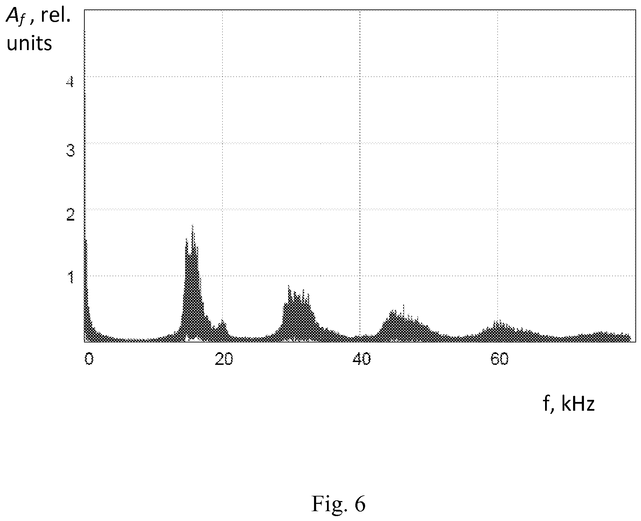

Fig. 6 depicts the Fourier transform of the waveform of the oscillations of the secondary current in the plasma during electron beam welding of 12X18H10T steel. A distinct peak in the spectral density can be seen at a frequency of approximately 17 kHz. The frequency distributions for all of the investigated materials have a similar appearance across the entire range analyzed. The frequency corresponding to the peak in the spectral density depends on the material being welded and the welding configuration and lies in the range from 5 kHz to 125 kHz (most commonly between 12-30 kHz). The peak in the spectral density in the transform of the waveform of the secondary current in the plasma reflects high-frequency processes in the "beam-channel-penetration-plasma" system, which often most closely correlate to the magnitude of the power density when welding.

The second claimed embodiment of the method is realized in the following manner.

The waveform of the secondary current in the plasma is filtered by isolating the waveform of the alternating component, which includes the frequency range containing the peak in the spectral density, from the transform of the oscillations of the secondary current in the frequency range 5-125 kHz. Then the filtered waveform is rectified. It is subsequently processed and the focusing current is regulated similarly to the way it was in the first embodiment of the method.

The method was tested on specimens of 15X5M steel in an electron beam welding apparatus with a ELA-60/60 power supply with 3.6 kW of welding power.

The waveform of the alternating component that includes the frequency range that contains the peak in the spectral density was isolated from the transform of the oscillations of the waveform of the secondary current in the plasma using a discrete bandpass filter. For 12X18H10T steel, a range of 12.5-25 kHz was applied. Results similar to those described below were obtained when narrower and broader ranges were chosen.

Then the filtered waveform is rectified and the resulting waveform is processed similarly to the original waveform *Data(t)* as in the first embodiment.

Fig. 5 shows the results of performing electron beam welding of steel with a 3-kW electron beam for 5 different levels of focus of the electron beam $\Delta I_f$ ($\Delta I_f = I_f - I_{fo}$; the level of focus determined by the difference between the values of the focusing current when welding and the sharp-focus current that maximizes weld penetration). The magnitudes of the delay $\Delta\tau_0$ of the function $S(\tau)$ relative to the waveform of the current in the deflection coils is presented, having been obtained by the method using the second embodiment. The sign and magnitude of the delay $\Delta\tau_0$ of the function $S(\tau)$ depend on the level of focus $\Delta I_f$, which decreases monotonically from positive values when under-focused to negative values when using an over-focused electron beam. Moreover, the results obtained using the second embodiment of the method are characterized by better linearity and make it possible to more accurately identify when the beam is focused.

**Claims**

1. A method of electron beam welding with operational control of the power density and level of focus of the electron beam, comprising:

- performing electron beam welding, wherein the electron beam is deflected by injecting linear, saw-toothed or sinusoidal oscillations in the frequency range from 300 to 2,000 Hz into a deflection current supplied to deflection coils (2) for deflecting the electron beam; and further **characterised by** the following steps :
- measuring, filtering and rectifying the waveform of a secondary current in the plasma generated during the welding process;
- processing the filtered-and-rectified or original waveform of the secondary current using a synchronous integration method to obtain a function S($\tau$), wherein the function S($\tau$) is obtained by the formula

$$S(\tau) = \int\limits^{t_0} g(t+\tau) \cdot Data(t)dt \, ,$$

where g(t+$\tau$) is a reference waveform generated from the waveform of the deflection current shifted by time $\tau$ (0<$\tau$<T, where T is the period of the deflection current), Data (t) is the waveform of the secondary current, t is time and $t_0$ is a sample time;
- measuring a value of a delay of the function S($\tau$) relative to a waveform of the deflection current supplied to the deflection coils (2);
- regulating a focusing current supplied to focusing coils (10) for focusing the electron beam while holding the value of the delay at a constant level that corresponds to a specified magnitude of the power density of the electron beam.

2. The method of claim 1, in which the value of the delay is held at a constant level equal to zero ensuring maximum weld penetration and speed for a given power level, which corresponds to a maximum power density in a weld zone.

3. The method of claim 1, in which the waveform of the secondary current is filtered by isolating a waveform of an alternating component which corresponds to a frequency range containing a peak in a spectral density of the secondary current from the Fourier transform of oscillations of the secondary current in the frequency range 5-125 kHz, in particular in the frequency range 12-30 kHz, and wherein the filtered waveform is rectified.


**Patentansprüche**

1. Verfahren zum Elektronenstrahlschweißen mit Funktionskontrolle der Leistungsdichte und Fokuslevel des Elektronenstrahls, welches umfasst:

- Durchführen des Elektronenstrahlschweißens, wobei der Elektronenstrahl abgelenkt wird durch Einspeisen von linearen, sägezahnartigen oder sinusförmigen Oszillationen im Frequenzbereich von 300 bis 2000 Hz in einen Ablenkspulen (2) zum Ablenken des Elektronenstrahls zugeführten Ablenkstrom; und ferner **gekennzeichnet durch** die folgenden Schritte:
- Messen, Filtern und Richten der Wellenform eines während des Schweißprozesses erzeugten Sekundärstroms im Plasma;
- Verarbeiten der gefilterten-und-gerichteten oder originalen Wellenform des Sekundärstroms, wobei eine synchrone Integrationsmethode verwendet wird, um eine Funktion S($\tau$) zu erhalten, wobei die Funktion S($\tau$) erhalten wird durch die Formel

$$S(\tau) = \int\limits_{0}^{t_0} g(t+\tau) \cdot Data(t)dt$$

worin g(t+$\tau$) eine Referenz-Wellenform ist, erzeugt aus der Wellenform des Ablenkstroms, verschoben um die Zeit $\tau$ (0<$\tau$ <T, worin T die Periode des Ablenkstroms ist), Data(t) die Wellenform des Sekundärstroms ist, t die Zeit ist und $t_0$ eine Abtastzeit ist;
- Messen eines Werts einer Verzögerung der Funktion S($\tau$) relativ zu einer Wellenform des Ablenkstroms, der den Ablenkspulen (2) zugeführt wird;
- Regulieren eines Fokussierstroms, der Fokussierspulen (10) zugeführt wird zum Fokussieren des Elektronenstrahls, während der Wert der Verzögerung auf einem konstanten Level gehalten wird, das einer spezifizierten Größe der Leistungsdichte des Elektronenstrahls entspricht.

**2.** Verfahren nach Anspruch 1, bei welchem der Wert der Verzögerung auf einem konstanten Level gleich Null gehalten wird, was eine maximale Schweißpenetration und Geschwindigkeit für ein gegebenes Leistungslevel sicherstellt, welches einer maximalen Leistungsdichte in einer Schweißzone entspricht.

**3.** Verfahren nach Anspruch 1, bei welchem die Wellenform des Sekundärstroms gefiltert wird durch Isolieren einer Wellenform einer alternierenden Komponente, welche einem Frequenzbereich entspricht, der einen Peak in einer spektralen Dichte des Sekundärstroms enthält, aus der Fourier-Transformation von Schwingungen des Sekundärstroms im Frequenzbereich 5-125 kHz, insbesondere im Frequenzbereich 12-30 kHz, und wobei die gefilterte Wellenform gerichtet wird.

**Revendications**

**1.** Méthode de soudage par faisceaux d'électrons avec un contrôle opérationnel de la densité de puissance et du niveau de concentration du faisceau d'électrons, comprenant:

- réalisation de soudage par faisceau d'électrons, où le faisceau d'électrons est dévié en injectant des oscillations linéaires, en dents de scie ou sinusoïdales, dans la gamme de fréquences de 300 à 2 000 Hz, dans un courant de déviation fournie à des bobines de déviation (2) pour dévier le faisceau d'électrons ; et **caractérisée en outre par** les étapes suivantes :
- mesure, filtration et rectification de la forme d'onde d'un courant secondaire dans le plasma généré au cours du processus de soudure;
- traitement de la forme d'onde filtrée et redressée ou original du courant secondaire en utilisant une méthode d'intégration synchrone pour obtenir une fonction S($\tau$), où la fonction S($\tau$) est obtenue par la formule

$$S(\tau) = \int_{0}^{t_0} g(t+\tau) \cdot Data(t)dt$$

où g(t+$\tau$) est une forme d'onde de référence générée à partir de la forme d'onde du courant de déviation décalée par le temps $\tau$ (0 < $\tau$ < T, où T est la période du courant de déviation), Data (t) est la forme d'onde du courant secondaire, t est le temps et $t_0$ est un temps d'échantillon;
- mesure d'une valeur d'un retard de la fonction S($\tau$) par rapport à une forme d'onde du courant de déviation fournie aux bobines de déviation(2) ;
- réglage d'un courant de concentration fournie à des bobines de concentration (10) pour focaliser le faisceau d'électrons tout en maintenant la valeur du retard à un niveau constant qui correspond à un niveau spécifié de la densité de puissance du faisceau d'électrons.

**2.** La méthode de la revendication 1, où la valeur du retard est maintenue à un niveau constant égal à zéro, assurant une pénétration et vitesse maximale de soudure pour un niveau de puissance donnée, ce qui correspond à une densité de puissance maximale dans une zone de soudure.

**3.** La méthode de la revendication 1, où la forme d'onde du courant secondaire est filtrée en isolant une forme d'onde d'un composant en alternance qui correspond à une gamme de fréquences contenant un pic dans une densité spectrale du courant secondaire à partir de la transformée de Fourier d'oscillations du courant secondaire de la gamme de fréquences de 5 à 125 kHz, en particulier dans la gamme de fréquences de 12 à 30 kHz, et dans laquelle la forme d'onde filtrée est rectifiée.

Fig. 1

Fig. 2

Fig. 3

Fig. 4

| Pass number | 1 | 2 | 3 | 4 | 5 |
|---|---|---|---|---|---|
| Level of focus $\Delta I_f$, mA | -15 | -7 | 0 | 7 | 14 |
| Cross-sections | | | | | |
| Joint depth, mm | 9.2 | 13.8 | 15.1 | 10.8 | 9 |
| Joint width at the top, mm | 4.5 | 4.9 | 4.7 | 5.6 | 6.5 |
| Magnitudes of the delay $\Delta \tau_0$, obtained using the first embodiment of the method, ms. | 0.119 | 0.079 | 0.02 | -0.01 | -0.02 |
| Magnitudes of the delay $\Delta \tau_0$, obtained using the second embodiment of the method, ms. | 0.262 | 0.089 | 0.022 | -0.02 | -0.056 |

Fig. 5

Fig. 6

**EP 2 888 070 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- RU 2183153
- JP S55100886 A
- GB 2026732 A
- GB 2345149 A

**Non-patent literature cited in the description**

- DATABASE. 1983-G0370K